# EUROPEAN PATENT SPECIFICATION

(11) **EP 0 239 052 B1**
(45) Date of publication and mention of the grant of the patent: **29.09.1993**
(21) Application number: 87104246.1
(22) Date of filing: 23.03.1987
(51) Int. Cl.: H05K 9/00, H01F 1/153

(54) **Magnetic-shielding material**
Material für magnetische Abschirmung
Matériau pour blindage magnétique

(30) Priority: 24.03.1986 JP 65345/86
(43) Date of publication of application: 30.09.1987
(73) Proprietor: KABUSHIKI KAISHA RIKEN, Chiyoda-ku Tokyo 102 (JP); SHIMIZU CONSTRUCTION Co. LTD., Chuo-ku Tokyo 104 (JP)
(72) Inventor: Ishii, Hiroyoshi, Kumagaya-shi Saitama-ken (JP); Suzuki, Kenzo, Kumagaya-shi Saitama-ken (JP); Kaneko, Misao, Kumagaya-shi Saitama-ken (JP); Ishikawa, Noboru, 4-17, Ecchujima 3-ch. Koto-ku Tokyo (JP)
(74) Representative: TER MEER STEINMEISTER & PARTNER GbR

(56) References cited:
- EP-A- 0 048 488
- EP-A- 0 218 183
- FR-A- 2 211 536
- GB-A- 2 135 679
- PATENT ABSTRACTS OF JAPAN, vol. 9, no. 148 (P-366)[1871], June 22, 1985 & JP-A-60-25011

## Description

### BACKGROUND OF THE INVENTION

### Field of the Invention

The present invention relates to a magnetic-shielding sheet.

### Description of the Prior Art

Precision electric instruments, such as those for measurement frequently cause errors in measurement values or erroneous operation when exposed to leakage flux from household electric appliances, office automation apparatus, building steel frames, etc. Also terrestrial magnetism may affect adversely precision electrical instruments. Thus for example, countermeasures are tentatively taken that a measurement room in which precision electrical instruments are disposed is enclosed with magnetic shielding material for protecting them against external magnetic field. As magnetic-shielding materials silicon steel sheet or permalloy are often used. These however are disadvantageous in having so poor magnetic-shielding ability that they are required to be processed into considerably thick sheets for use, reflecting on inconvenience and uneconomy.

Attention is being paid to amorphous alloys useful as various functional materials, which have distinguishable chemical and mechanical properties from those of crystalline alloys. Above all iron- or cobalt-based amorphous alloys do not have crystal anisotropy, and exhibit greatly superior soft magnetic properties associated with it, i.e. very small coercive force and high magnetic permeability. Thus they are promising to be put into practice by the utilization of these properties.

On the other hand, amorphous alloys are usually available in the form of ribbon (several tenths µm in thickness and 100 mm in width), which must be cut into pieces and laminated to be processed into sheets of desired dimensions. In this processing, cutting may be accompanied by occasional damage, and lamination presents problems of superposition and bonding. Besides, a desired thickness is obtainable only by laminating a number of layers, thus with many processes, reflecting unfavorably on productivity.

GB-A-2 135 679 discloses an electromagnetic shielding material of ferromagnetic amorphous alloy flakes dispersed in a polymer matrix.

EP-A-0 048 488 discloses a plastic housing for shielding against electric and/or magnetic fields, wherein said housing comprises a laminate of a plastic and a metallic nonwoven, in particular steel wool. As shown in the figures, said laminate of plastic and metallic nonwoven may be interposed between non-metal laminates. Thus, the laminate of plastic and metallic nonwoven of this document is a composite material consisting of a plastic material which is reinforced by a metallic nonwoven.

### OBJECT AND SUMMARY OF THE INVENTION

Accordingly, it Is an object of the present invention to provide a magnetic-shielding sheet superior In magnetic-shielding ability against external magnetic fields including static and low frequency magnetic fields and high in productivity.

As the result of a concentrated endeavor of study, the inventors have discovered that a magnetic amorphous alloy is processed into flakes, and a magnetic-shielding material comprising laminated magnetic amorphous alloy flakes is made. The thus-obtained material remaining to have the above-mentioned satisfactory superior properties of magnetic amorphous alloy and besides having high productivity. On the basis of this, the present invention has been accomplished.

The magnetic-shielding sheet according to the invention as defined in claim 1 is a construction material having a layer of soft magnetic amorphous alloy flakes with a thickness of 20-60 µm and an aspect ratio (ratio of maximum length to maximum thickness) of 50-10,000.

Soft magnetic amorphous alloy flakes (referred to as amorphous alloy flakes hereinafter) of less than 5µm in thickness are difficult to make and those exceeding 100µm in thickness sparingly become amorphous. Therefore suitable thicknesses are within the range between 20 and 60µm.

In amorphous alloy flakes, aspect ratios less than 10 are associated with lower magnetic permeability, and accompanied by a change in magnetic characteristic. Additionally, lamination becomes difficult. Thus in this case, the magnetic-shielding ability becomes deteriorated, On the other hand, aspect ratios exceeding 15,000 makes the work for amorphous alloy flakes troublesome and the productivity lower.

### BRIEF DESCRIPTION OF THE DRAWINGS

The drawings illustrate embodiments of the present invention:
Fig.1 is a plane view of a magnetic-shielding material;
Fig.2 is a cross-sectional view of the same in an enlarged scale;
Fig.3 is a schematically-illustrative view of the parts of a leakage flux measuring instrument;

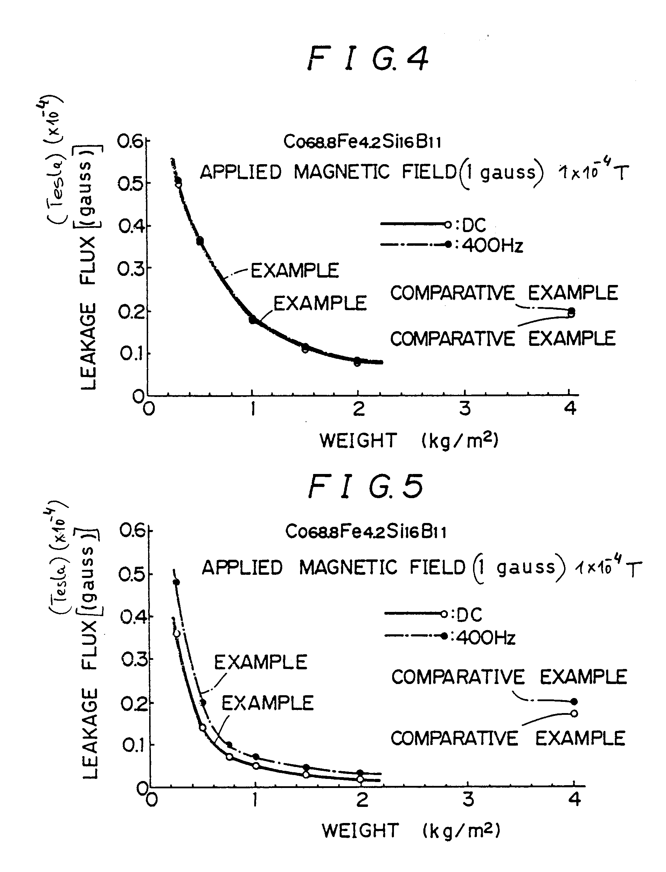

Figs.4 and 5 are graphical representations, with a magnetic-shielding material, of the relationship between the leakage flux under an impressed magnetic field and the weight per unitary area (kg/m²);
Fig.6 is a graphic representation of a magnetic field strength-leakage flux curve;
Fig.7 is a graphic representation, with a magnetic-shielding material, of the relationship between the leakage flux under an impressed magnetic field of 2 x 10⁻⁴ T (2 gausses) and the weight per unitary area (kg/m²);
Fig.8 is a graphic representation, with a dual component (two types of amorphous alloy flakes) magnetic-shielding material, of the relationship between the magnetic field strength and the leakage flux; and
Fig.9 is a graphic representation of the relationship at a different aspect ratio between the leakage flux and the weight per unitary area (kg/m²).

### DESCRIPTION OF THE PREFERRED EMBODIMENTS

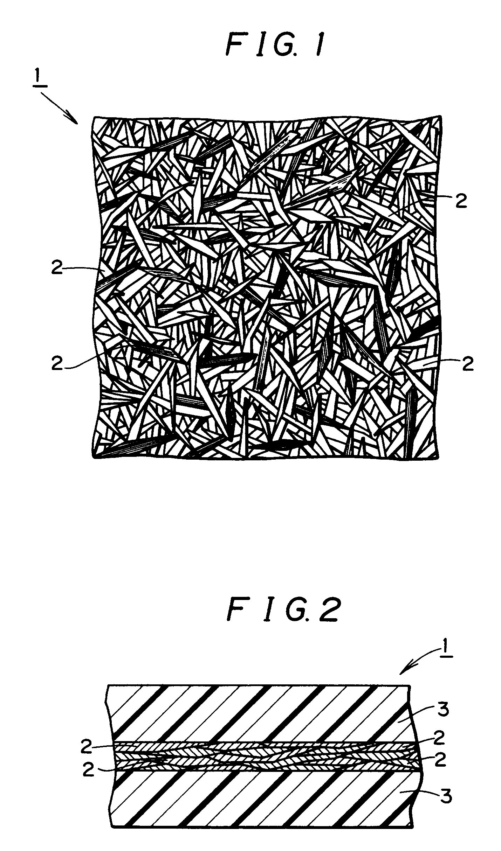

Figs.1 and 2 show a plane view with the reference character 3-designated upper sheet removed and an enlarged crosssectional view, respectively, of a magnetic-shielding sheet embodying the invention.

The magnetic-shielding sheet 1 is a construction material consisting of two outer non-metal films 3 of acryl, vinyl chloride, epoxy or phenol resin and a layer 2 of amorphous alloy flakes interposed between them.

The magnetic-shielding sheet is manufactured by uniformly distributing predeterminedly-weighed amorphous alloy flakes between the films 3 and subsequently setting them therebetween. This can be accomplished very easily, in particular without needing any binder. An additional alternative embodiment of the invention may be suitably chosen, for example, the so-called hot melting method comprising uniformly distributing soft magnetic amorphous alloy flakes between two films, one or both of which are provided on the internal surface with a binder resin coated, then heating under pressure to cause the binder resin to melt and penetrate among the amorphous alloy flakes, and subsequently causing them with the aid of the binder resin to be bound together to form an integrated magnetic-shielding sheet. In this case, individual amorphous alloy flakes 2 are distributed uniformly and directed at random, thus to form undirectional lamination. On the other hand, lamination of amorphous alloy ribbon or crystalline alloy strip is inevitably accompanied by repeated cutting and complex binding in cross directions and a variety of angle degrees for undirectional arrangement, with the consequent much troublesome work. Furthermore, as an alternative embodiment of the invention, directional arrangement of the amorphous alloy flakes, if desired, can be realized by subjecting them to uniform distribution under the condition where somewhat magnetic field is applied, thereby the amorphous alloy flakes are arranged in their longitudinal direction.

The use of resin film may impart flexibility to the magnetic-shielding material to make it convenient to be used for some purposes. Such a flexible magnetic-shielding material can be manufactured by the so-called vacuum packing technique comprising uniformly distributing amorphous alloy flakes between two resin films and subsequently causing them to adhere closely under reduced pressure between them.

In the method for preparing a magnetic shielding sheet according to the invention comprising causing two films between which amorphous alloy flakes are distributed to adhere closely under reduced pressure between them, the amorphous alloy flakes are forced to get together more densely and compactly with the effect of improving the magnetic-shielding ability.

The magnetic-shielding ability of the amorphous alloy flake is based on its chemical composition involved in soft magnetism. The cobalt-based amorphous alloy flake of magnetostriction (-10 to +10) x 10⁻⁶ and magnetic permeability 1000 or more has a somewhat relatively low magnetic flux density and, a magnetic-shielding material containing such flakes is required to have a somewhat larger thickness against strong magnetic fields but exhibits extremely good magnetic-shielding ability against weak magnetic fields. Against strong magnetic fields, the iron-based amorphous alloy flake of saturated magnetic flux density 1.2 T (12000 gausses) or more exhibits a good magnetic-shielding ability even if used for a magnetic-shielding material of small thickness. An effective magnetic-shielding over the range of from strong magnetic fields to very weak magnetic fields up to the terrestrial magnetism results from disposition in layers or mixed state of cobalt-based amorphous alloy flakes of magnetostriction (-10 to +10) x 10⁻⁶ and magnetic permeability 1000 or more and iron-based amorphous alloy flakes saturated of magnetic flux density 1.2 T (12000 gauses) or more.

Amorphous alloy flakes can be manufactured by cutting ribbon or the known melt/extraction method. It is preferred from the view point of productivity and capability of thinning the edges of amorphous alloy squamose flakes to apply the cavitation process disclosed in Japanese laid-open patent No. 6907/1983, which comprises feeding a molten metal on the surface of a roller running at a high speed, the surface having a relatively small wettability to the molten metal, to brake the molten metal into fine molten droplets, and subsequently dashing the droplets against a metallic rotary member running at a high speed to solidify rapidly them.

The invention will be described more fully by way of examples hereinafter:

### Example 1

According to the above-mentioned cavitation process, amorphous alloy flakes of an elemental composition: Co 68.8%, Fe 4.2%, Si 16% and B 11% (referred to as C_{68.8}Fe_{4.2}Si₁₆B₁₁) were prepared and their properties were as follows: magnetostriction 0, saturated magnetic flux density 0.7 T (7000 gausses), magnetic permeability 10000, average thickness 40µm and aspect ratio 200 to 500.

Using the obtained amorphous alloy flakes, the magnetic-shielding material 1 as illustrated in Figs.1 and 2 was manufactured under ordinary pressure according to the above-described process. The outer layers 3 were of acrylic resin and bound together at their edges by the use of a binder (not shown).

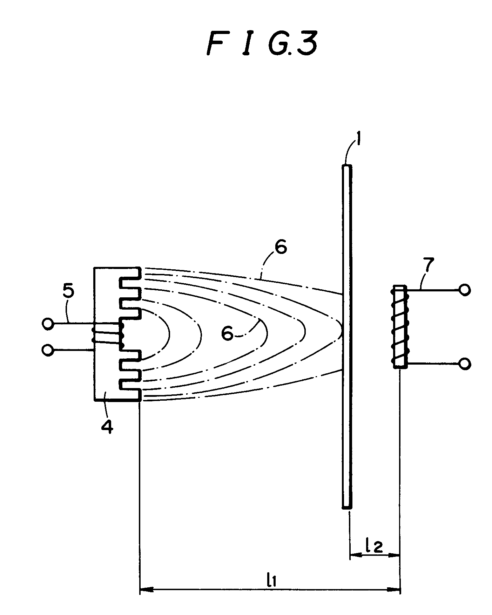

The resulting magnetic-shielding material in the form of a construction sheet was investigated with respect to its magnetic-shielding ability with an apparatus shown in Fig.3, in the following way: There is provided a magnetic field source which comprises a core 4 consisting of electromagnetic steel sheets or silicon steel sheets and a magnetizing coil 5 wound about the core 4. Exciting current was caused to flow through the magnetizing coil 5, and magnetic flux 6 was generated from the magnetic field source. Then the strength of leakage flux through the magnetic-shielding material 1 was measured by means of a detection coil 7 at a distance of 100mm (designated by l₁ in the Figure) from the end plane of the core 4. On the basis of the thus-obtained results, the magnetic-shielding ability was evaluated. The magnetic-shielding material 1 was disposed at a distance of 15mm (designated l₂ in the Figure) from the detection coil 7 towards the core 4. The strength of magnetic field which reflects magnetic flux 6 can be changed with exciting current through the magnetizing coil 5.

Using the instrument illustrated in Fig.3, the leakage flux transmitting through a sample of magnetic-shielding material was measured. The magnetizing coil 5 was connected to DC and AC (400Hz) power supply, respectively. A group of magnetic-shielding materials containing magnetic-shielding flakes, of which weights per unitary area (kg/m²) vary serially, were used to obtain the characteristic curve. In this Example, applied magnetic field was 1 x 10⁻⁴ T (1 gauss). The results obtained are graphically represented in Fig .4.

For comparison are shown also the results of a similar measurement of an undirectional silicon steel sheet of 0.5mm thickness commercially available. In this example, the results yielded by application of DC and AC (or static or alternating magnetic field), respectively, were substantially the same. The material obtained in this example gave substantial the same value with 1kg/m² as that with 4kg/m² of the undirectional silicon steel sheet used as reference, this demonstrates that the former with about 1/4 of the weight/m² of the latter,is equivalent in the magnetic-shielding ability to the latter. It is a matter of course that an increase in weight/m² of the material contributes to an improvement in the magnetic-shielding.

### Example 2

Except that the amorphous alloy flakes obtained in Example 2 were uniformly distributed under reduced pressure of 133 Pa (1 Torr), the process was carried out in the same way as in Example 1 to attain magnetic-shielding materials in the form of construction sheets.

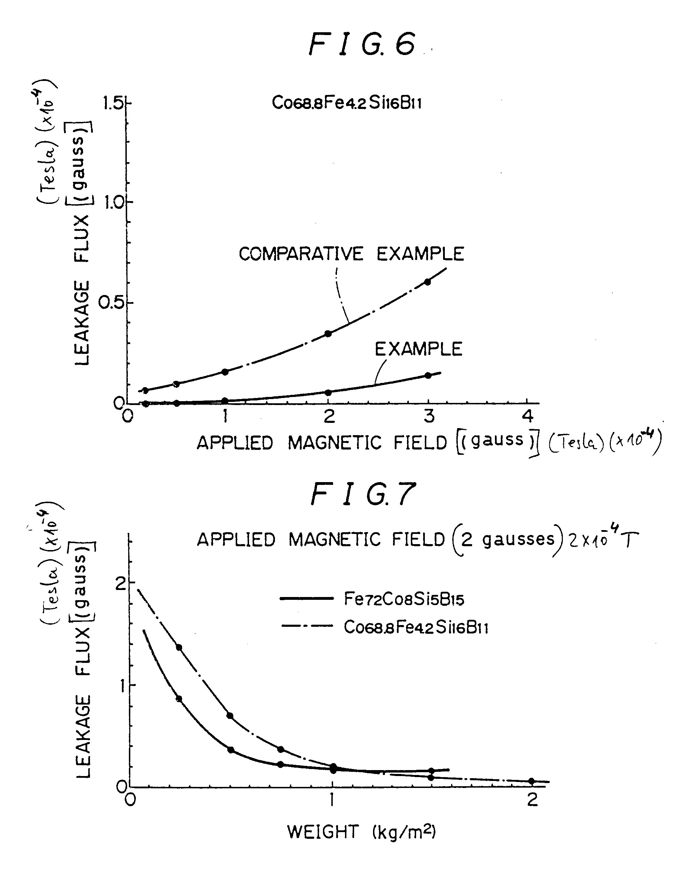

The obtained magnetic-shielding materials were measured in the same way as in Example 1, and the yielded results are as graphically shown in Fig.5, in which the results of the undirectional silicon steel sheets of 0.5mm thickness as reference are shown, too.

As Fig.5 shows, against static magnetic field, the magnetic-shielding ability with 0.4kg/m² is substantially equivalent to that of the undirectional silicon steel sheet. In other words, the equivalent magnetic-shielding ability is attainable with 1/10 of the weight/m² compared with the reference, this enables a great reduction of the necessary weight of the magnetic-shielding material. Besides substantially the same magnetic shielding ability as against static magnetic field was exhibited against alternating magnetic field.

Fig.6 shows graphically the comparative results of the material of this Example (1.8kg/m²) and the reference (undirectional silicon steel sheet of 4kg/m²) measured at varying strengths of impressed magnetic field.

As seen from Fig.6, the material obtained in this Example, with less than a half of the weight/m² of the reference, exhibited remarkably superior magnetic-shielding ability at any applied magnetic field strength. Complete shielding by this material is shown against the terrestrial magnetism.

### Example 3

In the same way as in Example 1, amorphous alloy flakes of a chemical composition Fe₇₂Co₈Si₅B₁₅ were prepared, and the properties measured were magnetostriction +40 x 10⁻⁶, saturated magnetic flux density 1.65 T (16500 gausses), average thickness 40µm and aspect ratio 200 to 500.

Using the amorphous alloy flakes, magnetic-shielding materials in the form of construction sheets were manufactured under reduced pressure of 133 Pa (1 Torr) in the same way as in Example 2.

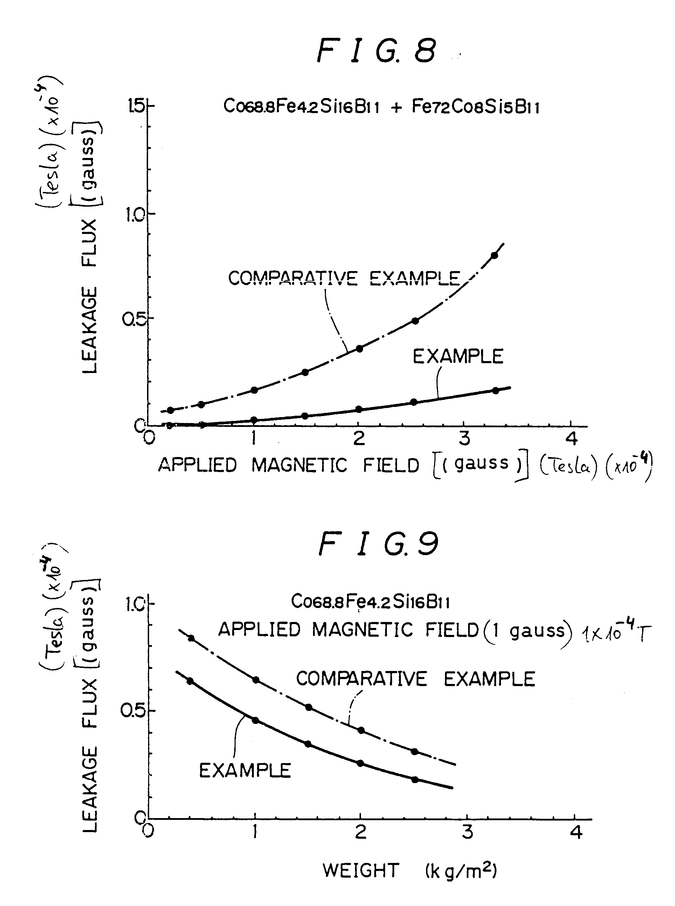

Leakage flux measurement was carried out in the same manner as above-mentioned, of 2 types of magnetic-shielding material, one obtained in this Example and the other containing Co_{68.8}Fe_{4.2}Si₁₆B₁₁ flakes obtained in Example 2. A static magnetic field 2 x 10⁻⁴ T (2 gausses) was applied. The obtained results are graphically represented in Fig. 7.

The magnetic-shielding material containing the Co_{68.8}Fe_{4.2}Si₁₆B₁₁ amorphous alloy flakes (referred to as Co_{68.8}Fe_{4.2}Si₁₆B₁₁ laminated material) exhibited a good magnetic-shielding ability against a weak magnetic field of 1 x 10⁻⁴ T (1 gauss) as above-stated in Example 1 but was slightly inferior to the magnetic-shielding material containing the Fe₇₂Co₈Si₅B₁₅ amorphous alloy flakes (referred to as Fe₇₂Co₈Si₅B₁₅ laminated material) against a strong magnetic field of 2 x 10⁻⁴ T (2 gausses) because of its lower magnetic flux density of 0.7 T (7000 gausses). To say in other words, against a strong magnetic field of 2 x 10⁻⁴ T (2 gausses), the Fe₇₂Co₈Si₅B₁₅ laminated material which had a higher saturated magnetic density exhibited with smaller kg/m² a superior magnetic-shielding ability to that of the Co_{68.8}Fe_{4.2}Si₁₆B₁₁ laminated material. Within the range of up to about 1 kg/m², the Fe₇₂Co₈Si₅B₁₅ laminated material exhibited a superior magnetic-shielding ability.

### Example 4

Two types of Co_{68.8}Fe_{4.2}Si₁₆B₁₁ and Fe₇₂Co₈Si₅B₁₅ amorphous alloy flakes obtained in Example 1 and 3 were blended together in a mixing ratio of 1 to 1, and processed under reduced pressure of 133 Pa (1 Torr) in the same way as in Examples 2 and 3, respectively, into a magnetic-shielding material of 1 kg/m² in the form of construction sheet.

This magnetic-shielding materials and the undirectional silicon steel sheet (thickness 0.5mm, 4kg/m²) as reference were measured about leakage flux at varying strengths of static magnetic field applied.

The yielded results are graphically represented in Fig.8, which indicates that the material obtained in this example with 1/4 of the weight/m² of the reference exhibited a very good magnetic-shielding ability compared with the reference.

### Examples 5

Following the cavitation technique, there were prepared two types of amorphous alloy flakes, one having a chemical composition Co_{68.8}Fe_{4.2}Si₁₆B₁₁, an average thickness 40µm and an aspect ratio of 3 to 10 (as reference) and the other which is the same except for an aspect ratio of 50 to 100. The aspect ratio can be changed with the circumferential speed of the running roller.

Amorphous alloy flakes (a predetermined amount) of each of the above-mentioned types were distributed and set between two sheets to form a magnetic-shielding material in the same way as in Example 1, which were measured about magnetic-shielding characteristics.

The yielded results, as graphically shown in Fig. 9, demonstrate that the reference (aspect ratio 3 to 10) exhibited a lower magnetic-shielding ability than that of the material with an aspect ratio of 50 to 100.

Moreover, amorphous alloy flakes of less than 5µm thickness failed to be prepared, and similar alloy flakes obtained exceeding 100µm in thickness was observed to contain crystalline portions.

The results yielded in these Examples demonstrate the features and effects of the magnetic-shielding sheets according to the invention as summarized in the following:
(1) The structure in which soft magnetic amorphous alloy flakes are laminated produces a small coercive force and a high magnetic permeability, resulting in a remarkably good magnetic shielding ability, which enables effective shielding against external magnetic fields.
(2) The amorphous alloy flakes having a thickness of 5 to 100µm and an aspect ratio of 50 to 10,000 can be contained in compact state or minimized space in the magnetic-shielding material, contributing to an efficient magnetic-shielding.
(3) The above-stated dimensions of the amorphous alloy flakes permit easier lamination of them with the effect of a high productivity of the magnetic-shielding material.

It is a matter of course that, instead of cobalt-based and iron-based amorphous alloy flakes used in the Examples above-described, those containing as base constituent nickel, or any mixture of at least 2 selected from the group consisting of cobalt, iron and nickel may be used.

## Claims

1. A magnetic-shielding sheet against static and low frequency magnetic fields having flexibility and comprising a laminated-structural layer of soft magnetic amorphous alloy flakes being interposed between non-metal films, each of said soft magnetic amorphous alloy flakes being 20 to 60 µm thick and having an aspect ratio of 50 to 10,000 (ratio of maximum length to maximum thickness).

2. A magnetic shielding sheet as claimed in Claim 1, wherein said soft magnetic amorphous alloy flakes are cobalt-based amorphous alloy flakes of magnetostriction (-10 to + 10)x10⁻⁶ and magnetic permeability 1000 or more.

3. A magnetic shielding sheet as claimed in Claim 1, wherein said soft magnetic amorphous alloy flakes are ironbased amorphous alloy flakes of magnetic flux density 1.2 T (12000 gausses) or more.

4. A magnetic shielding sheet as claimed in Claim 1, wherein said soft magnetic amorphous alloy flakes are composed of cobalt-based amorphous alloy flakes of magnetostriction (-10 to + 10)x10⁻⁶ and magnetic permeability 1000 or more and iron-based amorphous alloy flakes of magnetic flux density 1.2 T (12000 gausses) or more.

5. A magnetic shielding sheet as claimed in Claim 1, wherein said soft magnetic amorphous alloy flakes are laminated in the state uniformly distributed and directed at random.

6. A magnetic shielding sheet as claimed in Claim 1, wherein said soft magnetic amorphous alloy flakes are flaked or squamose pieces.

## Patentansprüche

1. Magnetabschirmblatt gegenüber statischen und Niederfrequenz-Magnetfeldern, welches Flexibilität aufweist und eine laminierte Strukturschicht aus weichmagnetischen amorphen Legierungsflocken, welche zwischen nichtmetallischen Folien eingebracht sind, umfaßt, wobei jede der weichmagnetischen amorphen Legierungsflocken 20 bis 60 µm dick ist und ein Aspektverhältnis von 50 bis 10000 (Verhältnis der maximalen Länge zur maximalen Dicke) aufweist.

2. Magnetabschirmblatt nach Anspruch 1, wobei die weichmagnetischen amorphen Legierungsflocken amorphe Legierungsflocken auf Cobaltbasis mit einer Magnetostriktion von (- 10 bis + 10) x 10⁻⁶ und einer magnetischen Permeabilität von 1000 oder mehr sind.

3. Magnetabschirmblatt nach Anspruch 1, wobei die weichmagnetischen amorphen Legierungsflocken amorphe Legierungsflocken auf Eisenbasis mit einer Magnetflußdichte von 1,2 T (12000 Gauss) oder mehr sind.

4. Magnetabschirmblatt nach Anspruch 1, wobei die weichmagnetischen amorphen Legierungsflocken aus amorphen Legierungsflocken auf Cobaltbasis mit einer Magnetostriktion von (- 10 bis + 10) x 10⁻⁶ und einer magnetischen Permeabilität von 1000 oder mehr und amorphen Legierungsflocken auf Eisenbasis mit einer Magnetflußdichte von 1,2 T(12000 Gauss) oder mehr zusammengesetzt sind.

5. Magnetabschirmblatt nach Anspruch 1, wobei die welchmagnetischen amorphen Legierungsflocken in einem gleichmäßig dispergierten und statistisch ausgerichteten Zustand laminiert worden sind.

6. Magnetabschirmblatt nach Anspruch 1, wobei die welchmagnetischen amorphen Legierungsflocken geflockte oder schuppige Stücke sind.

## Revendications

1. Feuille de blindage magnétique réalisant une protection vis-à-vis de champs magnétiques statiques et à basse fréquence, présentant une certaine flexibilité et comprenant une couche structurelle stratifiée de lamelles d'alliage amorphe magnétique doux interposées entre des pellicules non métalliques, chacune desdites lamelles d'alliage amorphe magnétique doux possède une épaisseur comprise entre 20 et 60 µm et ayant un taux d'élancement de 50 à 10 000 (rapport de la longueur maximale à l'épaisseur maximale).

2. Feuille de blindage magnétique selon la revendication 1, dans laquelle lesdites lamelles d'alliage amorphe magnétique doux sont des lamelles d'alliage amorphe à base de cobalt possédant une magnétostriction égale à (-10 à + 10) x 10⁻⁶ et une perméabilité magnétique égale à 1000 ou plus.

3. Feuille de blindage magnétique selon la revendication 1, dans laquelle lesdites lamelles d'alliage amorphe magnétique doux sont des lamelles d'alliage amorphe à base de fer possédant une densité de flux magnétique égale à 1,2T (12 000 gauss) ou plus.

4. Feuille de blindage magnétique selon la revendication 1, dans lequel lesdites lamelles d'alliage amorphe magnétique doux sont constituées par des lamelles d'alliage amorphe à base de cobalt possédant une magnétostriction égale à (-10 à +10) x 10⁻⁶ et une perméabilité magnétique égale à 1000 ou plus et par des lamelles d'alliage amorphe à base de fer possédant une densité de flux magnétique égale à 1,2T (12 000 gauss) ou plus.

5. Feuille de blindage magnétique selon la revendication 1, dans laquelle lesdites lamelles d'alliage amorphe magnétique doux sont superposées dans un état uniformément distribué et sont orientées de façon aléatoire.

6. Feuille de blindage magnétique selon la revendication 1, dans laquelle lesdites lamelles d'alliage amorphe magnétique doux sont des éléments en forme de copeaux ou d'écailles.
